# FASCICULE DE BREVET EUROPEEN

(11) **EP 3 376 666 B1**
(45) Date de publication et mention de la délivrance du brevet: **20.05.2026**
(21) Numéro de dépôt: 17186779.9
(22) Date de dépôt: 18.08.2017
(51) Int. Cl.: H03B 5/12

(54) **DISPOSITIF D'OSCILLATEUR LOCAL À FAIBLE CONSOMMATION**
LOKALOSZILLATORVORRICHTUNG MIT GERINGEM VERBRAUCH
LOCAL OSCILLATOR DEVICE WITH LOW POWER CONSUMPTION

(30) Priorité: 14.03.2017 FR 1752076
(43) Date de publication de la demande: 19.09.2018
(73) Titulaire: STMicroelectronics (ALPS) SAS, 38000 Grenoble (FR); STMicroelectronics (Grenoble 2) SAS, 38000 Grenoble (FR)
(72) Inventeur: AYRAUD, Michel, 38340 Voreppe (FR); RAMET, Serge, 38560 Jarrie (FR); LEVEL, Philippe, 38120 Saint Égrève (FR)
(74) Mandataire: Casalonga

(56) Documents cités:
- GB-A- 2 497 137
- US-A1- 2009 325 510
- US-A1- 2015 214 891
- US-B1- 9 071 193
- US-B2- 6 946 924

## Description

Des modes de réalisation de l'invention concernent les circuits intégrés, en particulier les oscillateurs à faible consommation d'énergie, par exemple dans des systèmes d'émetteurs-récepteurs.

Les systèmes d'émetteur-récepteur comportent généralement des oscillateurs locaux permettant de générer des signaux d'oscillateur local à des fréquences d'intérêt, par exemple de l'ordre du Gigahertz, permettant notamment d'effectuer des transpositions de fréquences.

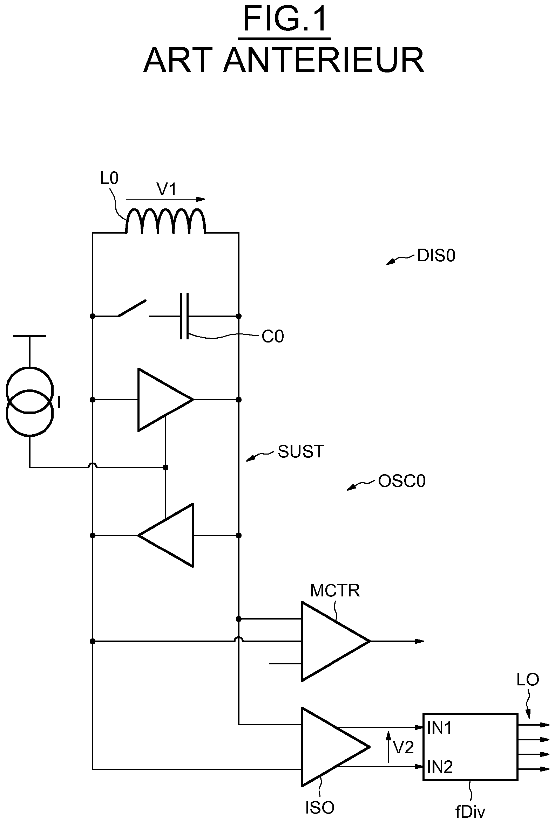

La figure 1 représente un exemple d'un dispositif d'oscillateur local DIS0 habituel.

L'oscillateur local DIS0 comporte un module oscillateur OSCO, dans lequel un élément inductif L0 et un élément capacitif C0 montés en parallèle forment un résonateur LC classique et connu en soi, générant un signal oscillant V1 aux bornes de l'élément inductif L0.

Les éléments L0 et C0 d'un tel module oscillateur OSCO sont habituellement choisis pour satisfaire à un compromis entre notamment le bruit de phase, la consommation énergétique et la surface occupée.

Un amplificateur de maintien SUST, alimenté par une source de courant I, permet d'entretenir les oscillations du signal V1 en compensant des pertes résistives.

Un tel montage offre de bonnes performances en matière de bruit de phase, de consommation énergétique et de surface occupée par le circuit.

Un diviseur de fréquence fDiv divise la fréquence du signal oscillant présent sur l'élément inductif L0 afin que le résonateur LC puisse être configuré pour générer un signal oscillant V1 à une fréquence plus élevée. En effet, cela permet de réduire la surface occupée par l'élément inductif L0 et de réduire le couplage entre l'oscillateur OSCO et le signal de sortie du diviseur fDiv ou d'une version amplifiée de ce signal, puisque les fréquences fondamentales des signaux délivrés par OSCO et fDiv sont différentes.

Le signal d'oscillateur local LO est délivré en sortie du diviseur de fréquence fDiv, généralement sous la forme d'un créneau en tension.

Pour produire un tel signal le diviseur de fréquence fDiv doit recevoir sur son entrée un signal dont l'amplitude est significativement supérieure aux seuils des transistors qu'il comporte.

Cependant, des signaux de forte amplitude accentuent l'effet « varactor » sur les transistors de l'étage d'entrée de fDiv, c'est-à-dire la variation de la composante capacitive de leur impédance d'entrée, ce qui a pour conséquence d'ajouter du bruit de phase à l'oscillateur OSCO. Plus globalement cet effet se produit également sur tous les autres composants connectés au résonateur LC, tels que l'amplificateur de maintien SUST et le moyen de contrôle d'amplitude MCTR. Ainsi, de tels oscillateurs locaux DIS0 sont habituellement équipés d'un amplificateur tampon ISO permettant d'une part d'isoler le résonateur LC des entrées du diviseur de fréquence fDiv, et d'autre part de générer un signal amplifié V2 d'amplitude suffisante pour les besoins en entrée du diviseur de fréquence fDiv, à partir du signal oscillant V1.

En effet, la valeur capacitive sur les entrées de l'amplificateur tampon ISO est suffisamment faible et suffisamment peu sensible à l'effet « varactor » pour ne pas perturber le résonateur LC.

Par contre, ce type d'amplificateur tampon ISO présente l'inconvénient d'avoir un gain variable avec de nombreux facteurs, tels que la température, la fréquence du signal sur son entrée, ou encore les aléas de fabrication. En outre ce type d'amplificateur tampon ISO a tendance à dégrader le rapport cyclique du signal sur son entrée (c'est-à-dire le rapport entre le temps à l'état haut et la période dudit signal).

Par conséquent, une solution habituelle consiste à surdimensionner l'amplificateur tampon ISO afin qu'il soit moins sensible à ces facteurs, mais cela engendre une surconsommation énergétique indésirable.

La publication US9071193B1 décrit un dispositif de l'état de l'art.

Par conséquent il existe le besoin de limiter la consommation énergétique de ce type d'oscillateur local, sans réduire ses performances.

Ainsi, selon un aspect, il est proposé un dispositif d'oscillateur local comportant un module oscillateur possédant un premier élément inductif et un élément capacitif monté en parallèle, et un diviseur de fréquence couplé au module oscillateur pour délivrer un signal d'oscillateur local.

Selon une caractéristique générale de cet aspect, le dispositif d'oscillateur local comporte un autotransformateur comprenant le premier élément inductif et deux deuxièmes éléments inductifs respectivement couplés aux bornes du premier élément inductif et à deux bornes de sortie de l'autotransformateur, lesdites bornes de sortie étant par ailleurs couplées à des bornes d'entrée du diviseur de fréquence.

On rappelle ici qu'un autotransformateur est un transformateur dont les circuits primaires et secondaires ont une partie commune.

Ainsi, les deux deuxièmes éléments inductifs de l'autotransformateur fournissent une oscillation d'amplitude accrue et suffisante pour respecter les exigences susmentionnées en entrée du diviseur de fréquences.

Cela permet de s'affranchir de l'amplificateur tampon tout en entretenant un niveau bas d'oscillation dans le module oscillateur, un bruit de phase adéquat et une surface occupée inchangée.

En outre, l'autotransformateur permet d'obtenir un nouveau degré de liberté dans l'architecture du circuit intégré en plaçant les bornes de sortie à un autre emplacement que les bornes du premier élément inductif.

Par exemple les bornes du premier élément inductif sont situées sur un premier côté de la périphérie de l'autotransformateur, et les bornes de sortie sont chacune située sur un autre côté de la périphérie de l' autotransformateur.

Avantageusement, les bornes de sortie sont situées sur un deuxième côté de la périphérie de l'autotransformateur opposé au premier côté par rapport à un point central de l'autotransformateur.

Le point central de l'autotransformateur peut être par exemple un centre géométrique, tel qu'un centre de symétrie de l'autotransformateur.

Cela permet de placer les bornes de sortie du transformateur à un endroit plus commode pour la connexion à l'entrée du diviseur fréquence, et ainsi économiser de l'espace. En outre cela permet d'éviter une dégradation du facteur de qualité du module oscillateur habituellement introduite par de nombreuses et longues pistes conductrices couplées à ses bornes.

Selon un mode de réalisation dans lequel le premier élément inductif comporte une première piste conductrice plane ayant une forme de spirales entrelacées, et les deuxièmes éléments inductifs comportent chacun une deuxième piste conductrice plane ayant une forme de spirale, lesdites deuxièmes pistes conductrices étant entrelacées entre elles et situées en périphérie du premier élément inductif, le rapport de la largeur des deuxièmes pistes conductrices sur la largeur de la première piste conductrice est avantageusement compris entre 0.1 et 0.7.

En effet, les deuxièmes éléments inductifs peuvent comporter des pistes plus étroites que celles du premier élément inductif, sans restreindre le facteur de qualité du module oscillateur notamment car la puissance délivrée sur les bornes de sorties est faible par rapport à la puissance nécessaire au module oscillateur.

Par conséquent, la surface initialement occupée par un premier élément inductif seul est sensiblement inchangée ici.

Selon un mode de réalisation dans lequel le diviseur de fréquence est configuré pour diviser la fréquence d'un signal ayant une amplitude supérieure à une amplitude seuil, le module oscillateur est configuré pour générer un signal oscillant d'amplitude inférieure à l'amplitude seuil sur les bornes du premier élément inductif, et l'autotransformateur est configuré pour générer un signal amplifié du signal oscillant sur lesdites bornes de sortie, d'amplitude supérieure à l'amplitude seuil.

Le dispositif d'oscillateur local est avantageusement réalisé de façon intégrée au sein d'un circuit intégré.

Un système émetteur-récepteur, comprenant une antenne destinée à émettre et recevoir des signaux radiofréquence, une chaîne d'émission et une chaîne de réception couplées à l'antenne, comporte avantageusement un dispositif d'oscillateur local tel que défini ci-avant et couplé auxdites chaînes d'émission et de réception.

Un appareil électronique, tel qu'un téléphone portable ou une tablette tactile, comporte avantageusement un tel système émetteur-récepteur.

D'autres avantages et caractéristiques de l'invention apparaîtront à l'examen de la description détaillée de modes de réalisation, nullement limitatifs, et des dessins annexés sur lesquels :
- la figure 1, précédemment décrite, représente un oscillateur local classique ;
- les figures 2 à 5 représentent des exemples de modes de réalisation de l'invention ;

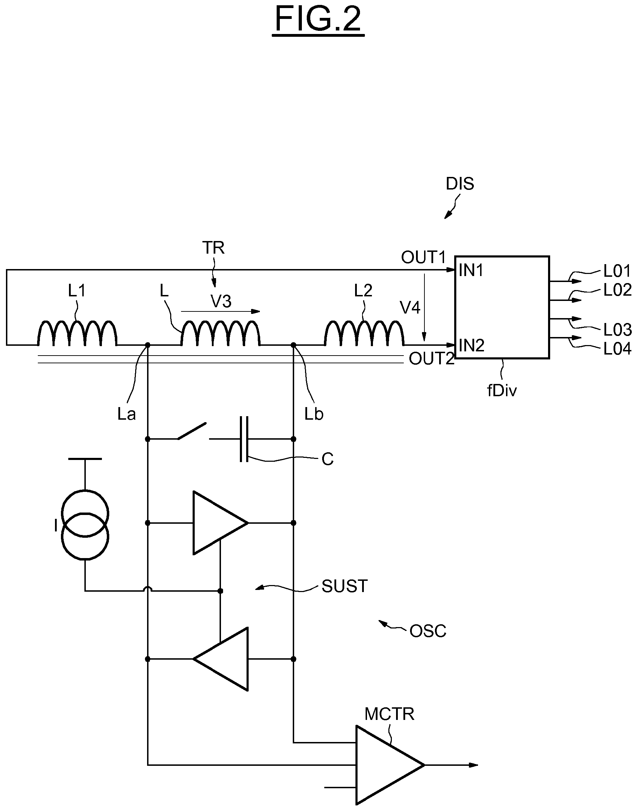

La figure 2 représente un dispositif d'oscillateur local DIS par exemple réalisé de façon intégré au sein d'un circuit intégré.

Le dispositif d'oscillateur local DIS comporte un module oscillateur OSC possédant un premier élément inductif L et un élément capacitif C montés en parallèle, du type résonateur LC.

L'élément capacitif C peut par exemple comporter une banque d'éléments capacitifs élémentaires en parallèle, couplés ou non au premier élément inductif L par l'intermédiaire d'interrupteurs commandables. Cela permet notamment de pouvoir ajuster la valeur capacitive de l'élément capacitif C.

Le module oscillateur OSC génère de manière habituelle un signal oscillant V3 sur les bornes La et Lb du premier élément inductif L. L'amplitude du signal oscillant V3 peut par exemple être de 0,5 volt.

Le module oscillateur OSC comporte d'autre part un amplificateur de maintien SUST alimenté par une source de courant I, et connecté en parallèle au résonateur LC. L'amplificateur de maintien SUST permet d'entretenir les oscillations du signal V3 en compensant des pertes résistives, et de contrôler l'amplitude de l'oscillation grâce à l'ajustage du courant I par l'intermédiaire d'un moyen de contrôle de l'amplitude MCTR.

Le dispositif d'oscillateur local DIS comporte un diviseur de fréquence fDiv, configuré dans cet exemple pour communiquer en sortie deux signaux d'oscillateur local LO1, LO3 en quadrature de phase, et deux signaux d'oscillateur local LO2, LO4 respectivement en opposition de phase avec lesdits signaux en quadrature de phase LO1, LO3.

Les signaux LO1-LO4 en sortie du diviseur de fréquence fDiv sont à une fréquence proportionnelle à la fréquence du signal V4 présent entre les deux entrées IN1, IN2 du diviseur de fréquence fDiv.

Par exemple le diviseur de fréquence peut diviser la fréquence du signal V4 sur son entrée par 2 ou par 4.

Le diviseur de fréquence fDiv, par exemple réalisé en technologie CMOS, nécessite pour son fonctionnement un signal en entrée d'amplitude supérieure à une amplitude seuil.

Cette amplitude seuil provient notamment de la tension seuil nécessaire pour enclencher une commutation d'un transistor CMOS, et doit être par exemple supérieure à 1 volt. Un autotransformateur TR permet de générer sur ses bornes de sorties OUT1, OUT2 un signal V4 de niveau d'amplitude supérieur à l'amplitude seuil en entrée du diviseur de fréquence fDiv, à partir d'un signal oscillant V3 généré par le dispositif oscillateur OSC ayant un niveau d'amplitude inférieur à ladite amplitude seuil.

L'autotransformateur TR comprend le premier élément inductif L en tant que circuit primaire, et un circuit secondaire comprenant deux deuxièmes éléments inductifs L1, L2. Les deuxièmes éléments inductifs L1, L2 sont respectivement couplés aux bornes La, Lb du premier élément inductif L d'une part et à deux bornes de sortie OUT1, OUT2 de l'autotransformateur TR d'autre part.

Les bornes de sorties OUT1, OUT2 de l'autotransformateur TR sont directement couplées aux bornes d'entrée IN1, IN2 du diviseur de fréquence fDiv, lui transmettant le signal V4.

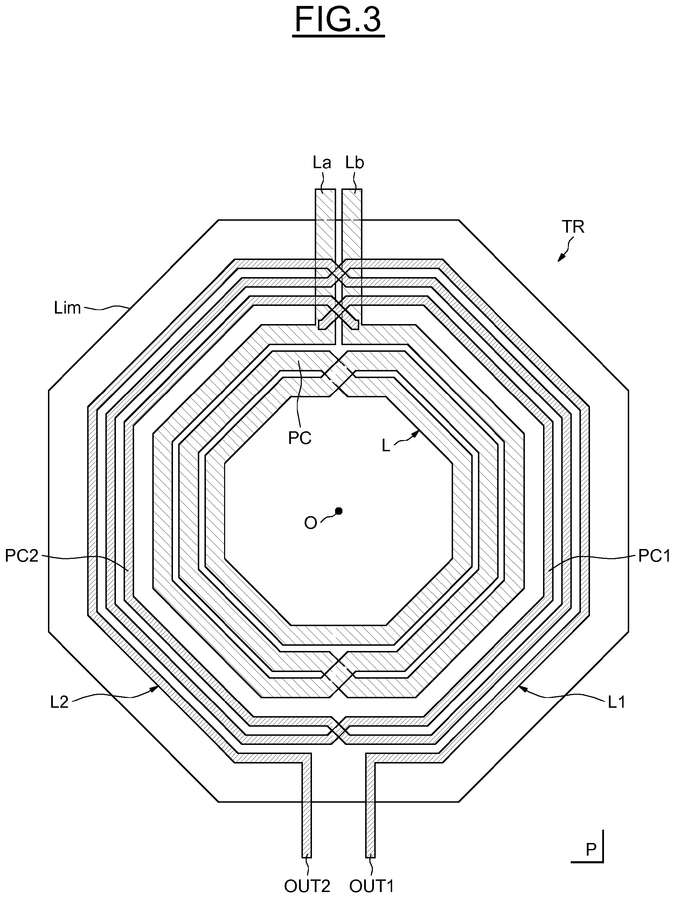

La figure 3 représente un mode de réalisation d'un autotransformateur TR avantageusement intégré selon l'invention au dispositif DIS décrit en relation avec la figure 2.

L'autotransformateur TR comporte le premier élément inductif L réalisé par une première piste conductrice PC, par exemple en métal et située dans les premiers niveaux d'interconnexions d'un circuit intégré.

L'autotransformateur TR comporte deux deuxièmes éléments inductifs L1, L2, également réalisés par des deuxièmes pistes conductrices respectives PC1, PC2, par exemple en métal et situées dans les premiers niveaux d'interconnexions du circuit intégré.

Dans la description en rapport avec la figure 3, le premier élément inductif L pourra être désigné par le terme de circuit primaire, et les deuxièmes éléments inductifs L1, L2 par le terme de circuit secondaire.

La piste conductrice PC du circuit primaire L est réalisée dans un plan P, et présente une forme de spirales entrelacées.

Plus précisément la piste conductrice PC, en partant de la borne La, suit un parcours ayant dans sa première moitié une forme de spirale octogonale qui s'enroule dans un premier sens puis ayant dans sa deuxième moitié une forme de spirale octogonale se déroulant dans le même sens, de façon entrelacée avec l'enroulement de la spirale de la première moitié du parcours, jusqu'à la borne Lb.

La piste conductrice PC comporte n spires (c'est-à-dire n circonvolutions), n étant un nombre entier, avec n=2 dans la représentation de la figure 3.

La largeur de la piste métallique PC est par exemple comprise entre 10µm et 20µm.

Le circuit secondaire comporte deux deuxièmes pistes conductrices PC1 et PC2 entrelacées entre elles et situées en périphérie du premier élément inductif L.

La première de ces deuxièmes pistes conductrices PC1, est également réalisée dans le plan P et présente une forme de spirale octogonale qui s'enroule dans le même premier sens, en partant de la borne OUT1 jusqu'à la borne La. La piste conductrice PC1 forme le premier des deuxièmes éléments inductif L1, couplé au premier élément inductif L sur sa borne La.

La deuxième de ces deuxièmes pistes conductrices PC2, est également réalisée dans le plan P et présente aussi une forme de spirale octogonale qui se déroule dans le premier sens, en partant de la borne Lb jusqu'à la borne OUT2, de façon entrelacée avec l'enroulement de la première deuxième piste conductrice PC1. La piste conductrice PC2 forme le deuxième des deuxièmes éléments inductif L2, couplé au premier élément inductif L sur sa borne Lb.

Les pistes conductrices PC1, PC2 du circuit secondaire comportent par exemple chacune n/2 spires, n étant le nombre de spires de la piste conductrice PC du circuit primaire.

Par ailleurs, les pistes conductrices PC1, PC2 du circuit secondaire peuvent être plus étroites que la piste conductrice PC du circuit primaire, par exemple selon un rapport de largeur compris entre 0,1 et 0,7.

L'autotransformateur TR présente une forme globale octogonale dans l'exemple représenté par la figure 3, mais pourrait avoir d'autres formes, par exemple carré ou circulaire. Un point O situé au milieu de l' autotransformateur TR désigne un point central. Le point central O est sensiblement un point de symétrie de la forme de l'autotransformateur, aux positions des bornes et des croisements près.

Le contour octogonal Lim définit une zone de protection pour l'autotransformateur TR à l'intérieur de laquelle tout signal autre que celui de l'oscillateur est exclu.

Ainsi, il est visible sur la figure 3 que la réalisation des deuxièmes éléments inductifs L1, L2 de l'autotransformateur TR n'occupent substantiellement pas plus de surface que la surface occupée par l'élément inductif L seul.

Ainsi, par couplage électromagnétique de l'autotransformateur TR, la tension V4 entre les bornes de sortie OUT1, OUT2 peut s'exprimer : V4 = (1/2)*V3+V3+(1/2)*V3 = 2*V3, dans cet exemple avec n spires dans le circuit primaire et n/2 spires dans chaque élément inductif L1, L2 du circuit secondaire.

Les éléments inductifs L, L1, L2 de l'autotransformateur TR sont dimensionnés de façon à ce que le signal V3 soit optimisé pour le module oscillateur OSC, par exemple en matière de bruit de phase et d'occupation de surface, et de façon à ce que le signal V4 soit d'amplitude au moins égale à l'amplitude seuil du diviseur de fréquence fDiv.

En outre, dans l'exemple représenté par la figure 3, les bornes La, Lb du premier élément inductif L sont situées sur un premier côté de l'octogone, en périphérie de l'autotransformateur TR.

Les bornes de sortie OUT1, OUT2 sont quant à elles situées sur le côté opposé à ce premier coté. Les bornes de sortie OUT1, OUT2 pourraient être situées sur un autre côté de l'autotransformateur TR, et pas nécessairement sur le même coté, en fonction des besoins notamment en matière de nombre de spires et d'architecture du circuit intégré.

Dans une telle configuration, il est possible de placer le diviseur de fréquence fDiv du côté des sorties OUT1, OUT2 de l'autotransformateur, ce qui permet de décongestionner la charge sur les bornes La, Lb du premier élément inductif L, et de réduire la taille des chemins électriques reliant le module oscillateur OSC notamment aux entrées du diviseur de fréquence fDiv.

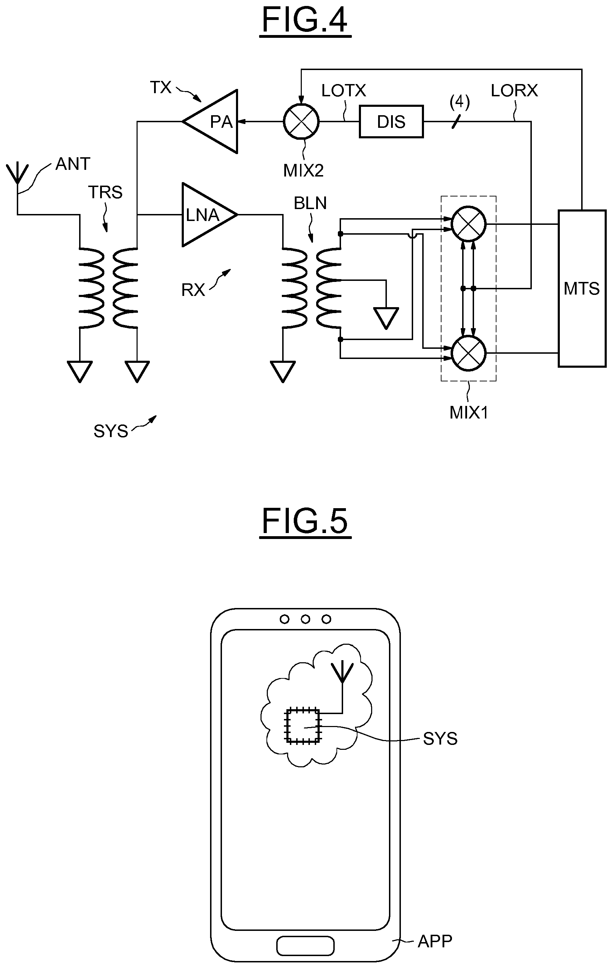

La figure 4 représente un exemple simplifié d'un système émetteur-récepteur SYS par exemple configuré pour communiquer à des fréquences de l'ordre du Gigahertz, comportant avantageusement un dispositif d'oscillateur local DIS tel que précédemment décrit en relation avec les figures 2 et 3.

Le système émetteur-récepteur SYS comprend un étage de réception RX et un étage d'émission TX.

L'étage de réception RX comporte classiquement un amplificateur faible bruit LNA, transmettant le signal reçu par l'antenne ANT à un transformateur symétrique-asymétrique BLN (« balun » selon le terme usuel).

En sortie du transformateur balun BLN, le signal est en mode différentiel, et chaque composante différentielle du signal est mélangée par un mélangeur MIX1 avec un signal d'oscillateur local LORX fourni en sortie du diviseur de fréquence fDiv dudit dispositif DIS, ce qui permet d'effectuer des transpositions de fréquence, par exemple en bande de base.

Les signaux transposés sont ensuite traités par des moyens de traitement MTS, par exemple mis en œuvre en partie de façon logicielle au sein d'un processeur (processeur en bande de base par exemple).

L'étage d'émission TX comporte quant à lui un amplificateur de puissance PA configuré pour générer un signal d'émission amplifié sur l'antenne ANT, dont la fréquence porteuse est la fréquence d'un signal d'oscillateur local LOTX fourni en sortie du diviseur de fréquence fDiv dudit dispositif DIS.

Le signal reçu en entrée de l'amplificateur de puissance PA résulte d'une transposition de fréquence, dans le domaine radiofréquence, d'un signal émanant des moyens de traitement MTS, par exemple du processeur en bande de base, à l'aide du signal d'oscillateur local LOTX.

La figure 5 représente un exemple d'appareil électronique APP équipé d'un mode de réalisation d'un système de communication radiofréquence SYS tel que précédemment détaillés, ici un téléphone mobile. Il apparaîtra à l'homme du métier que les modes de réalisation d'un système de communication radiofréquence SYS ou d'un dispositif d'oscillateur local DIS selon l'invention peuvent être inclus à tout autre type d'appareil ou autre système connu et non-décrit ici.

Par ailleurs, l'invention n'est pas limitée aux modes de réalisation qui ont été décrits ci-avant mais en embrasse toutes les variantes, par exemple, l'architecture de l'autotransformateur, les différents composants du dispositif oscillateur ou encore le système radiofréquence ont été donnés à titre d'exemple.

## Revendications

1. Dispositif d'oscillateur local (DIS) comportant un module oscillateur (OSC) possédant un premier élément inductif (L) et un élément capacitif (C) montés en parallèle, et un autotransformateur (TR) comprenant le premier élément inductif (L) et deux deuxièmes éléments inductifs (L1, L2) respectivement couplés aux bornes (La, Lb) du premier élément inductif (L) et à deux bornes de sortie de l'autotransformateur (OUT1, OUT2),
**caractérisé en ce que**
le dispositif d' oscillateur local (DIS) comporte un diviseur de fréquence (fDiv) couplé au module oscillateur (OSC) pour délivrer un signal d'oscillateur local (LO, LO1-LO4), lesdites bornes de sortie (OUT1, OUT2) étant par ailleurs couplées à des bornes d'entrée (IN1, IN2) du diviseur de fréquence (fDiv) ;
le premier élément inductif comportant une première piste conductrice (PC) plane ayant une forme de spirales entrelacées, et les deuxièmes éléments inductifs (L1, L2) comportant chacun une deuxième piste conductrice (PC1, PC2) plane ayant une forme de spirale, lesdites deuxièmes pistes conductrices (PC1, PC2) étant entrelacées entre elles et situées en périphérie du premier élément inductif (L), dans lequel le rapport de la largeur des deuxièmes pistes conductrices (PC1, PC2) sur la largeur de la première piste conductrice (PC) est compris entre 0,1 et 0,7.

2. Dispositif selon la revendication 1, dans lequel les bornes (La, Lb) du premier élément inductif (L) sont situées sur un premier côté de la périphérie de l'autotransformateur (TR), et les bornes de sortie (OUT1, OUT2) sont chacune située sur un autre côté de la périphérie de l'autotransformateur (TR).

3. Dispositif selon la revendication 2, dans lequel les bornes de sortie (OUT1, OUT2) sont situées sur un deuxième côté de la périphérie de l'autotransformateur (TR) opposé au premier côté par rapport à un point central (O) de l'autotransformateur (TR).

4. Dispositif selon l'une quelconque des revendications précédentes, le diviseur de fréquence (fDiv) étant configuré pour diviser la fréquence d'un signal ayant une amplitude supérieure à une amplitude seuil, dans lequel le module oscillateur (OSC) est configuré pour générer un signal oscillant (V3) d'amplitude inférieure à l'amplitude seuil sur les bornes (La, Lb) du premier élément inductif (L), et l'autotransformateur (TR) est configuré pour générer un signal amplifié (V4) du signal oscillant (V3) sur lesdites bornes de sortie (OUT1, OUT2), d'amplitude supérieure à l'amplitude seuil.

5. Dispositif selon l'une quelconque des revendications précédentes, réalisé de façon intégrée au sein d'un circuit intégré (CI).

6. Système émetteur-récepteur (SYS), comprenant une antenne (ANT) destinée à émettre et recevoir des signaux radiofréquence, une chaîne d'émission (TX) et une chaîne de réception (RX) couplées à l'antenne (ANT) et un dispositif selon l'une quelconque des revendications précédentes, couplé auxdites chaînes d'émission (TX) et de réception (RX).

7. Appareil électronique (APP), tel qu'un téléphone portable ou une tablette tactile, comportant un système émetteur-récepteur (SYS) selon la revendication 6.

## Patentansprüche

1. Lokale Oszillatorvorrichtung (DIS), die ein Oszillatormodul (OSC), das ein erstes induktives Element (L) und ein kapazitives Element (C) besitzt, die parallel geschaltet sind, und einen Autotransformator (TR) umfasst, der das erste induktive Element (L) und zwei zweite induktive Elemente (L1, L2) enthält, die jeweils an die Klemmen (La, Lb) des ersten induktiven Elements (L) und an zwei Ausgangsklemmen des Autotransformators (OUT1, OUT2) gekoppelt sind,
**dadurch gekennzeichnet, dass** die lokale Oszillatorvorrichtung (DIS) einen Frequenzteiler (fDiv) umfasst, der mit dem Oszillatormodul (OSC) gekoppelt ist, um ein lokales Oszillatorsignal (LO, LO1-LO4) zu liefern, wobei die Ausgangsklemmen (OUT1, OUT2) ferner mit Eingangsklemmen (IN1, IN2) des Frequenzteilers (fDiv) gekoppelt sind; wobei das erste induktive Element eine erste flache Leiterbahn (PC) in Form von verschachtelten Spiralen umfasst und die zweiten induktiven Elemente (L1, L2) jeweils eine zweite flache Leiterbahn (PC1, PC2) in Form einer Spirale umfassen, wobei die zweiten Leiterbahnen (PC1, PC2) miteinander verschachtelt sind und sich an der Peripherie des ersten induktiven Elements (L) befinden, wobei das Verhältnis der Breite der zweiten Leiterbahnen (PC1, PC2) zu der Breite der ersten Leiterbahn (PC) zwischen 0,1 und 0,7 liegt.

2. Vorrichtung nach Anspruch 1, wobei sich die Klemmen (La, Lb) des ersten induktiven Elements (L) auf einer ersten Seite der Peripherie des Autotransformators (TR) befinden, und die Ausgangsklemmen (OUT1, OUT2) sich jeweils auf einer anderen Seite der Peripherie des Autotransformators (TR) befinden.

3. Vorrichtung nach Anspruch 2, wobei sich die Ausgangsklemmen (OUT1, OUT2) auf einer zweiten Seite der Peripherie des Autotransformators (TR) gegenüber der ersten Seite in Bezug auf einen Mittelpunkt (O) des Autotransformators (TR) befinden.

4. Vorrichtung nach einem der vorhergehenden Ansprüche, wobei der Frequenzteiler (fDiv) so konfiguriert ist, dass er die Frequenz eines Signals mit einer Amplitude, die größer als eine Schwellenamplitude ist, teilt, wobei das Oszillatormodul (OSC) so konfiguriert ist, dass es ein oszillierendes Signal (V3) mit einer Amplitude, die kleiner als die Schwellenamplitude ist, an den Klemmen (La, Lb) des ersten induktiven Elements (L) erzeugt, und der Autotransformator (TR) so konfiguriert ist, dass er ein verstärktes Signal (V4) des oszillierenden Signals (V3) an den Ausgangsklemmen (OUT1, OUT2) mit einer Amplitude, die größer als die Schwellenamplitude ist, erzeugt.

5. Vorrichtung nach einem der vorhergehenden Ansprüche, die integriert in einer integrierten Schaltung (IC) hergestellt ist.

6. Sende-Empfangssystem (SYS), umfassend eine Antenne (ANT), die zum Senden und Empfangen von Funkfrequenzsignalen bestimmt ist, eine Sendekette (TX) und eine Empfangskette (RX), die mit der Antenne (ANT) gekoppelt sind, und eine Vorrichtung nach einem der vorhergehenden Ansprüche, die mit der Sendekette (TX) und der Empfangskette (RX) gekoppelt ist.

7. Elektronisches Gerät (APP), wie ein Mobiltelefon oder ein Touchscreen-Tablet, das ein Sende-Empfangssystem (SYS) nach Anspruch 6 umfasst.

## Claims

1. A local oscillator device (DIS) comprising an oscillator module (OSC) having a first inductive element (L) and a capacitive element (C) mounted in parallel, and an autotransformer (TR) comprising the first inductive element (L) and two second inductive elements (L1, L2) respectively coupled with the terminals (La, Lb) of the first inductive element (L) and with two output terminals of the autotransformer (OUT1, OUT2),
**characterised in that** the local oscillator device (DIS) comprises a frequency divider (fDiv) coupled to the oscillator module (OSC) to deliver a local oscillator signal (LO, LO1-LO4), said output terminals (OUT1, OUT2) being further coupled to input terminals (IN1, IN2) of the frequency divider (fDiv); the first inductive element comprising a first planar conductive track (PC) having the shape of interlaced spirals, and the second inductive elements (L1, L2) each comprising a second planar conductive track (PC1, PC2) having a spiral shape, said second conductive tracks (PC1, PC2) being interlaced with each other and located at the periphery of the first inductive element (L), wherein the ratio of the width of the second conductive tracks (PC1, PC2) to the width of the first conductive track (PC) is between 0.1 and 0.7.

2. The device according to claim 1, wherein the terminals (La, Lb) of the first inductive element (L) are located on a first side of the periphery of the autotransformer (TR), and the output terminals (OUT1, OUT2) are each located on another side of the periphery of the autotransformer (TR) .

3. The device according to claim 2, wherein the output terminals (OUT1, OUT2) are located on a second side of the periphery of the autotransformer (TR) opposite the first side relative to a central point (O) of the autotransformer (TR).

4. The device according to any of the preceding claims, the frequency divider (fDiv) being configured to divide the frequency of a signal having an amplitude greater than a threshold amplitude, wherein the oscillator module (OSC) is configured to generate an oscillating signal (V3) of amplitude less than the threshold amplitude on the terminals (La, Lb) of the first inductive element (L), and the autotransformer (TR) is configured to generate an amplified signal (V4) of the oscillating signal (V3) on said output terminals (OUT1, OUT2), of amplitude greater than the threshold amplitude.

5. The device according to any of the preceding claims, implemented in an integrated manner within an integrated circuit (CI).

6. A transceiver system (SYS), comprising an antenna (ANT) intended to transmit and receive radio frequency signals, a transmission chain (TX) and a reception chain (RX) coupled with the antenna (ANT) and a device according to any of the preceding claims, coupled with said transmission chains (TX) and reception chains (RX).

7. An electronic device (APP), such as a mobile phone or touchscreen tablet, comprising a transceiver system (SYS) according to claim 6.
